# EUROPEAN PATENT APPLICATION

(11) **EP 0 552 002 A1**
(43) Date of publication of application: **21.07.1993**
(21) Application number: 93300140.6
(22) Date of filing: 11.01.1993
(51) Int. Cl.: H02H 7/22, H02H 3/02, E06B 9/92, E06B 9/88

(54) **A breaker apparatus for connection between a power line and an external circuit, and a method of operation thereof**

(30) Priority: 16.01.1992 JP 5470/92
(71) Applicant: HITACHI, LTD., Chiyoda-ku, Tokyo 101 (JP)
(72) Inventor: Ohshita, Youichi, Katsuta-shi, Ibaraki 312 (JP); Sano, Yoshihiro, Katsuta-shi, Ibaraki 312 (JP); Hirasawa, Kunio, Hitachi-shi, Ibaraki 316 (JP); Kurosawa, Yukio, Hitachi-shi, Ibaraki 316 (JP); Kashimura, Katsuichi, Takahagi-shi, Ibaraki 318 (JP); Matsumoto, Morihisa, Kitaibaraki-shi, Ibaraki 319-15 (JP); Koyanagi, Osamu, Hitachi-shi, Ibaraki 316 (JP); Ishikawa, Koji, Mito-shi, Ibaraki 311-41 (JP)
(74) Representative: Calderbank, Thomas Roger

(57) **Abstract**

When a grounding fault occurs at a point 2 in a power line (1A), power line breakers (3A, 4A) at one or both ends of the power line (1A) are operated to disconnect the power line (1A) from external circuits (22A, 23A). Such disconnection may not immediately distinguish the current at the fault point 2 and therefore the ends of the power line (1A) are grounded by closing grounding switches (5A, 6A) connected thereto. The grounding switches (5A, 6A) have subsequently to be opened for normal operation to resume. If the current through the grounding switches (5A, 6A) is not zero, for example because a direct current component is induced in the power line (1A) by other adjacent power lines (1B, 1C), then the grounding switches (5A, 6A) may be damaged. Therefore, resistors (9, 10, 16) are placed in series with the grounding switches to attenuate any direct current component and/or the current through the grounding switches is monitored (11, 12) and the opening of the grounding switches is prevented when the current is non-zero.

## Description

The present invention relates to a breaker apparatus for connection between a power line and an external circuit, such as a transformer. It also relates to a method of operation of such a breaker apparatus. The breaker apparatus may be provided at one end of the power line, or a respective breaker apparatus may be provided at each end.

If a fault develops in a power line interconnecting two external circuits, for example power transformers in power sub-stations, it is necessary promptly to break the link between the power line and the external circuits. Therefore, a power breaker is connected to each power line so that one input of each power breaker thereof is connected to the corresponding end of the power line, and the other input of the power breaker is connected to the corresponding external circuit. Then, as soon as the fault is detected, the breakers are operated to disconnect the power line from the external circuits. One cause of faults requiring such disconnection are grounding faults due to external effects such as lightning.

However, the operation of the breakers at each end of the line do not immediately extinguish electrical arcing at the fault point, due to the induction of current from other adjacent power lines. Since such induction depends on the voltage on the power line, the effect of such arcing is particularly acute at high voltage lines, such as the 1,000kV lines that are currently being developed.

Therefore, it has previously been proposed that a grounding switch was connected between the input of the breaker which was connected to the power line and ground. That grounding switch was closed soon after the opening of the breaker, and the grounding of the ends of the power line forcibly reduced induced arcing. This then enabled the breakers to be re-closed quickly, thereby ensuring stability of the system.

In such a system, it is important that the grounding switches operate correctly. When an alternating current flows through the grounding switch, the grounding switch can be operated so that it opens when the current was at a zero value ("zero crossing"). However, if the grounding switch was faulty, it was possible that activations of opening of the switch did not break the electrical connection thereof, and arcing could then occur. Therefore JP-A-3-141523 proposed that current flowing through the grounding switch be monitored after the activation of opening thereof, to check that arcing was not occurring across the grounding switch. If a current was detected, corresponding to such arcing, the grounding switch was immediately re-closed. In practice, however, the grounding switch would be damaged by such arcing even if the duration thereof was kept short making use of the arrangement proposed in JP-A-3-141523.

The present invention is based on the realization that it is necessary to control the grounding switch of a breaker apparatus so that the grounding switch will not open when there is a significant current flowing therethrough. Again, it is possible to activate the switch at the zero-crossing point of an alternating current. However, conditions on the power line at the time of the fault may impose, on the alternating current, a significant DC component. That DC current will attenuate when the power line is disconnected, but the attenuation thereof may be slow. If the grounding switch is opened when a significant DC component of the current flows therethrough, the switch may be damaged by, for example, arcing.

Therefore, in a first aspect, the present invention proposes that a resistor be connected in series with the grounding switch. The use of such a resistor causes attenuation of the DC component of the current, so that that DC component of the current will rapidly fall to zero, permitting the grounding switch to be opened safely when the current is sufficiently small.

In a second aspect, it is proposed that the current flowing through the grounding switch, when the grounding switch is closed, be monitored, and the opening of the grounding switch be controlled so that the grounding switch is prevented from opening whilst there remains a significant DC current. This aspect differs from JP-A-3-141523 in that it is concerned with current monitoring when the grounding switch is closed, to prevent opening thereof, whilst JP-A-3-141523 is concerned with monitoring current after opening of the grounding switch to trigger re-closing thereof if necessary.

It is preferable that the grounding switch is not opened except when the current has a zero value. However, in practice it is possible for there to be a small current flowing through the grounding switch provided that current is sufficiently small that arcing will not be significant when the grounding switch is opened.

Although the first and second aspects of the present invention represent independent ways of solving the problem of damage due to opening of the grounding switch when a significant DC current is flowing, they may be inter-related in that current monitoring may be achieved by monitoring the current flowing in a resistor connected in series with the grounding switch. It is also possible, however, to use a current transformer or a Hall-effect element. In the former case, it is desirable that the current transformer has a core with a high magnetic flux saturation level. This prevents the core of the current transformer from reaching saturation due to the DC current, during the time for which the grounding switch is closed.

As previously mentioned, the present invention relates to both apparatus and method aspects of the present invention. Furthermore, although the above discussion has been concerned with a breaker apparatus at one end of a power line, such a breaker apparatus may be provided at each end of the power line. A common control may then be provided for controlling the switching of the grounding switches of each breaker apparatus. With such a common control, it is possible to control the direction of induced current in the power line, by suitable timing of the closing of the grounding switches of each breaker apparatus.

Embodiments of the present invention will now be described in detail, by way of example, with reference to the accompanying drawings, in which:
Fig. 1 shows schematically a power system having three power lines, by explaining the principles underlying the present invention;
Fig. 2 is a graph showing current flowing in a grounding switch of the embodiment of Fig. 1;
Fig. 3 shows schematically a power system having breaker apparatus according to the first embodiment of the present invention;
Fig. 4 is a diagram of a power system having breaker apparatus according to a second embodiment of the present invention;
Figs. 5A to 5C show examples of current detectors which may be used in the embodiments of Figs. 3 and 4;
Fig. 6 is a diagram of a power line corresponding to Fig. 1, by explaining further developments of the present invention;
Fig. 7 is a graph illustrating control timing in the present invention; and
Fig. 8 is a diagram of a power system incorporating a breaker apparatus according to a third embodiment of the present invention.

### 1. General principles

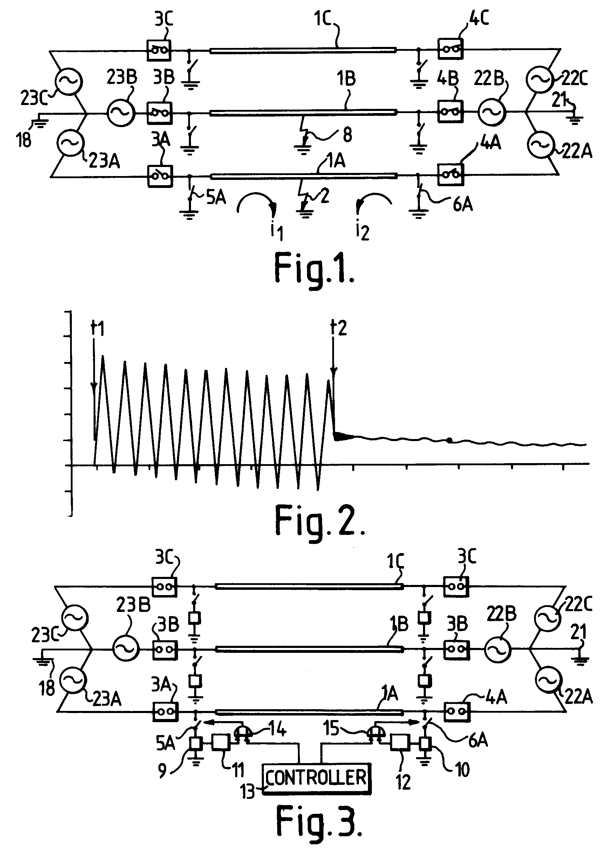

Referring first to Fig. 1, a power system has, for example, three power lines 1A, 1B, and 1C each connected between a first group of external circuits 22A, 22B, 22C at one end of the power lines 1A, 1B, 1C and a second group of external circuits 23A, 23B, 23C at the other end of the power lines 1A, 1B, 1C. The external circuits 22A, 22B, 22C, 23A, 23B, 23C may be, for example, circuits of a power sub-station such as transformer circuits. The external circuits at each end of the power lines 1A-1C are connected to respective earthing contacts 21, 18. A current breaker 3A to 3C, 4A to 4C is connected between each end of the respective power lines 1A to 1C and the corresponding external circuits 22A to 22C, 23A to 23B.

Suppose that a grounding fault occurs at an intermediate point 2 of the power line 1A due to, for example, lightning. Then, a ground current develops which is interrupted by the breakers 3A, 4A at the ends of the power line 1A. Suppose further that a similar grounding fault occurs at same point 8 in another power line 1B.

Although the breakers 3A, 4A disconnect the power line 1A from the external circuits 23A, 22A, arcing at the grounding fault point 2 will not cease immediately. Therefore, grounding switches 5A, 6A are connected between ground and the interconnection of the power line 1A and the breakers 3A, 4A. These grounding switches 5A, 6A are closed within a short time after the opening of breakers 3A, 4A to ground the ends of the power line 1A thereby seeking to eliminate arcing at the ground fault point 2.

However, the existence of the grounding fault at point 8 in line 1B causes currents i₁ and i₂ to be induced in the power line 1A due to the current flowing to ground fault point 8 in line 1B. The direct current component of the currents i₁, i₂ are determined by the phase of switching of the grounding switches 5A, 6A.

The effect of this is illustrated in Fig. 2, which shows the current flowing through one of the ground switches 5A, 6A. At time T₁, the grounding switch 5A, 6A is closed and an induced current flows through the grounding switch 5A, 6A which has a strongly alternating component. As can be seen from Fig. 2, that alternating component has a direct component imposed thereon (i.e. there is a DC current). The alternating component of the current is significant until a time T₂, at which arcing at the grounding fault point 2 ceases. After this time, the alternating component of the current falls so that it is significantly less than the component of the current. Hence, there remains a current flowing through the grounding switch 5A, 6A even after arcing at the grounding fault point 2 ceases.

The attenuation of the constant component of the current is determined by losses in the power system, and such systems are normally designed such that those losses are small, to improve power transmission efficiency, particularly at high rated voltages. This has the disadvantage that systems designed for high rated voltage only attenuate slowly direct component of the current. Normal design of grounding switches presupposes that the grounding switch is opened when the current is at a zero point. However, if the grounding switch is opened when the current has a significant direct component, as shown in Fig. 2 at a time T₂, then arcing can occur at the grounding switch 5A, 6A, thereby damaging it.

The effect of the direct component of the current is thus to create a state which will hereinafter be referred to as a "current zero-missing" state, since there is no zero point at which the grounding switch may operate.

### 2. Embodiments - Group 1

A first group of embodiments, which will now be described, are based on detection of the current flowing through the grounding switch of a breaker apparatus, to permit the opening of that grounding switch to be controlled such that opening is prevented when there is a non-zero DC component. Embodiments within this group also provide control of the closing of the switches, further to minimise the risk of incorrect opening.

A first embodiment of the present invention will now be described with reference to Fig. 3. The arrangement of the power system is generally similar to that of Fig. 1 and corresponding components are indicated by the same reference numerals. However, in addition to the power system shown in Fig. 1, current detecting elements 9 and 10 are connected in series with the grounding switches 5A and 6A. Similar current detecting elements may be connected in series with grounding switches 5B, 6B, and 5C and 6C. This makes it possible to determine when a current zero point occurs, using current zero point detectors 11 and 12 which measure the current waveform flowing to the grounding switch on the basis of the currents in the current detecting elements 9, 10.

In the embodiment of Fig. 1, logic gates 14, 15 carry out AND operations on the interruption commands for the grounding switches 5A, 6A, (which commands are issued by a central controller 13 which controls and manages the entire power system) and the output from the current zero point detectors 11 and 12. Hence, the interruption operation (i.e the opening) of the grounding switches can be prevented by detecting the current zero-missing state, should such a state occur. Then, the interruption operation of the grounding switches 5A, 6A is delayed until after a current zero point has appeared, due to attenuation of the DC current component. Thus, it is possible to prevent the breaker from being damaged by activation of an interruption operation when the current zero-missing state has occurred. Therefore, this first embodiment proposes that detection of the current zero-missing state and control of the interruption operation of the grounding switches are carried out in a locally closed system.

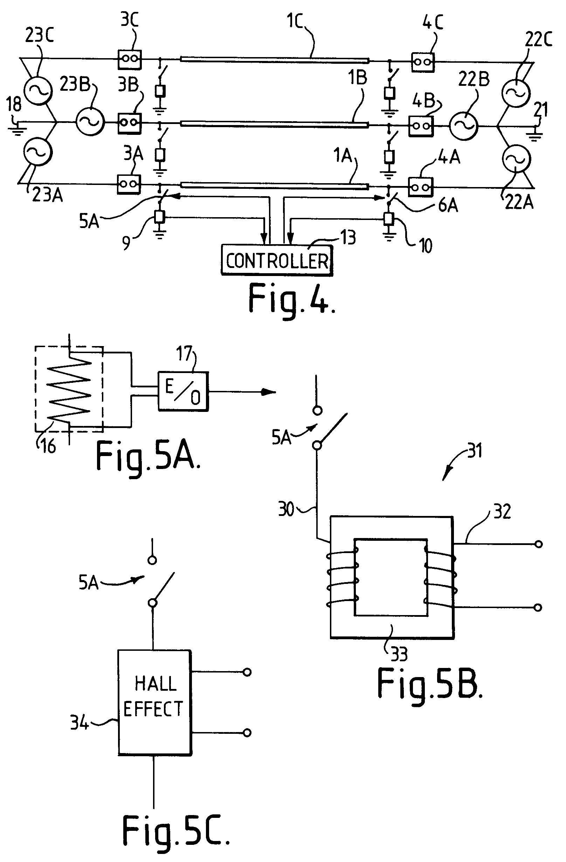

The second embodiment, shown in Fig. 4, is similar and again corresponding parts are indicated by the same reference numerals. In the embodiment of Fig. 4, the output from current detecting elements 9 and 10 is transmitted to the central controller 13; then the presence or absence of the zero-missing state is determined within the central controller 13 so that the interruption operation will be prevented when the current zero-missing state occurs. In the second embodiment, the current zero-missing state for the grounding switches at both ends of the power line 1A is considered for both ends simultaneously, so reliability of the consideration thereof is improved by double checking.

The current detecting elements 9 and 10 used in the embodiments above are necessary in order to detect the current zero-missing state. Hence, the direct component of the current must be within the component of the frequency band which can be measured, or the direct component of the current must be measured at least for several seconds. The current detecting elements 9,10 can be based on any one of: a direct current transformer using a Hall-effect element, measuring the voltage drop across a resistor connected in series with the corresponding grounding switch, and a current transformer which is designed to have a core with a sufficiently large magnetic flux density saturation that it does not saturate during operation.

Fig. 5A shows an example in which the voltage drop across a resistor connected in series with the grounding switch is measured. The resistor 16 is provided in the main circuit of the grounding switch, and a signal corresponding to the voltage drop is subjected to photoelectric conversion 17 and is transmitted to ensure noise resistance. Similarly, Fig. 5B shows an arrangement in which a connection 30 to the grounding switch 5A forms one winding of a current transformer 31, the other winding 32 of which provides a current measurement. The core 33 of the transformer should be such that it does not saturate during the time the grounding switch 5A is closed. Fig. 5C shows a Hall-effect element 34 connected to the grounding switch 5A for measuring the current therethrough.

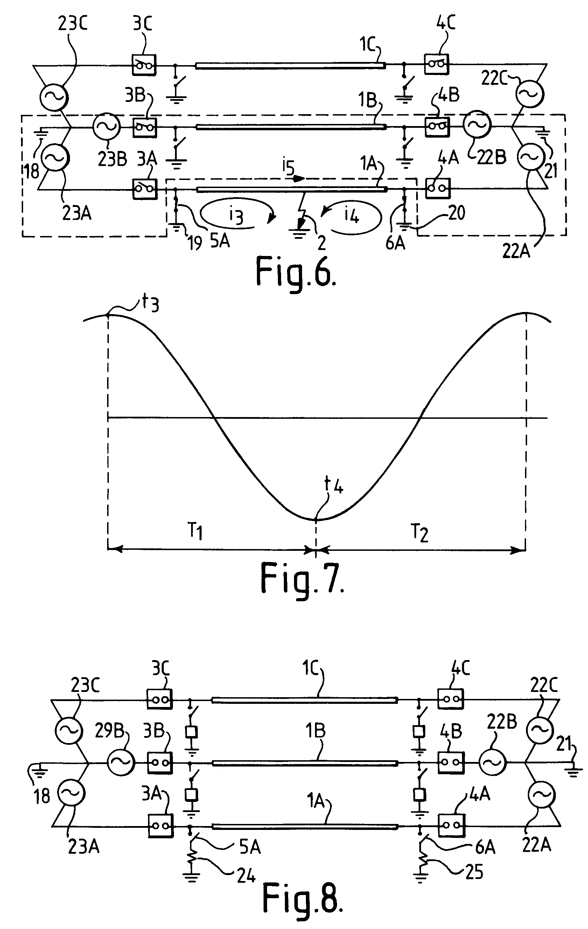

The direct component of the current flowing in the grounding switch can be attenuated by either of two modes, as will be discussed with reference to Fig. 6. Currents i₃ and i₄ represent direct current components flowing in the circuits on opposite sides of the fault point 2 at which arcing occurs. As illustrated, when the two direct currents i₃ and i₄ flow in opposite directions, a direct current flows to the ground through the arc at fault point 2 or through an elevated ground wire adjacent the power line, as shown by a solid line in Fig. 6. The circuit has a comparatively large resistance value, and the time constant for direct current attenuation may be of the order of several (? milli ?) seconds, so the current flow path causes comparatively large attenuation of the direct current component.

After extinction of the arc at the fault point 2, the currents i₃ and i₄ flow in opposite directions, so that they offset each other. Hence, the duration of the current zero-missing state for the grounding switches is minimized. By contrast, when the current i₃ and i₄ flow in the same direction, the current flow path will be as shown by the dotted line i₅ in Fig. 6. As can be seen, the current passes through the transmission lines 1A, 1B, which have comparatively small resistance. Therefore, the time constant for direct current attenuation is the order of hundreds of milliseconds, and the attenuation is very small. This will cause the problem that the zero-missing state is likely to be long.

In the embodiments discussed above, the directions of the direct currents i₃ and i₄ are related to the phase of operation of the grounding switches. As illustrated in Fig. 7, the phase of switch operation has a positive polarity with respect to the line voltage waveform during time T₁, and a negative polarity during time T₂. If the phase of operation of the grounding switches 5A, 6A at both ends of the power line 1A are controlled to be during time T₁ or T₂, then the attenuation will be large, in a similar way to current i₃ or i₄ illustrated by the solid line in Fig. 6. As far as polarity is concerned, a time difference equivalent to an integer multiple of the period T can be regarded as corresponding to the same phase.

When the time of operation of the grounding switches 5A, 6A corresponds to the voltage peak value at time points t₃ and t₄, there will be a symmetric current waveform which does not include a significant direct current component; this will provide a further advantage. The line voltage must then be measured in such a control system and the result must be reflected in the control arrangement. When the line voltage is not measured, it is preferable to minimize the difference between the times at which the grounding switches are operated. This will increase the probability that direct components of the current have the same polarity. Even if the polarities of those components are opposite, the absolute values are reduced. If it is possible, the range of operation time difference should be not more than T/6 with respect to the period T of the power frequency. Then the magnitude of the cyclic current, as indicated by the dotted line in fig. 6, can be controlled to a half or less of the maximum direct current.

### 3. Second group of embodiments

The second group of embodiments, represented by the embodiment of fig. 8, seeks to maximize attenuation of the DC current component.

In the embodiment of Fig. 3, the currents flowing through grounding switches 5A, 6A when those switches are closed will attenuate at a rate which is determined by the loses within the current paths. If the current detecting elements 9, 10 make use of the measurement of the voltage drop across a resistor connected in series with the corresponding grounding switch 5A, 6A, then that resistor will increase attenuation.

Therefore, in the embodiment of Fig. 6, there is no measurement of the current flowing in the grounding switches 5A, 6A, but nevertheless corresponding resistors 24, 25 are provided in series with the grounding switches 5A, 6A. Those resistors 24, 25 have a resistance with having a value sufficiently large to cause significant current attenuation. If the attenuation is large, the direct component of the current shown in Fig. 2 falls rapidly to zero, so that the grounding switches may be opened after a suitably short time. For example, if the resistance value of resistors 24, 25 is of the order of one to two ohms, the time constant for direct current component attenuation will be of the order of tens of milliseconds.

### 4. Summary

As described above, according to the present invention, a current detecting element which may measure the direct component of the current is connected in series with grounding switches provided on each end of a power line, thereby preventing the grounding switches from opening when a zero-missing state occurs. Furthermore, the absolute value of the direct component of the current, or its attenuation, may be increased by controlling the grounding switch operation time, and the direct current attenuation may be increased by providing a respective resistor in series with the high speed grounding switches. By providing one or more of these components, the present invention makes it possible to interrupt the secondary arc current maintained by induction even when the zero-missing state occurs in the grounding switches, thereby enabling high speed multi-phase re-closing and preventing accidental cutoff at the time of a ground fault.

## Claims

1. A breaker apparatus for connection between a power line (1A, 1B, 1C) and an external circuit (22A to 22C; 23A to 23B), said breaker system comprising:
a power line breaker (3A to 3C; 4A to 4C) having a first input for connection to said power line (1A, 1B, 1C) and a second input for connection to said external circuit (22A to 22C; 23A to 23C); and
a grounding switch (5A, 6A) connected between said first input of said power line breaker (3A to 3C; 4A to 4C) and ground;
characterized in that:
a resistor (9, 10) is connected in series with said grounding switch (5A, 6A).

2. A breaker apparatus according to claim 1, wherein said resistor (9, 10) is arranged to attenuate direct current flowing in said grounding switch (5A, 6A).

3. A breaker apparatus according to claim 1 or claim 2, further comprising: current detection means (17) for detecting current flowing in said resistor and for generating an output; and control means (13) for controlling said grounding switch in dependence on said output of said current detection means (17).

4. A breaker apparatus for connection between a power line (1A, 1B, 1C) and an external circuit (22A to 22C; 23A to 23C), comprising:
a power line breaker (3A to 3C; 4A to 4C) having a first input for connection to said power line (1A, 1B, 1C) and a second input for connection to said external circuit (22A to 22C; 23A to 23C); and
a grounding switch (5A, 6A) connected between said first input of said power line breaker (3A to 3C; 4A to 4C) and ground;
characterized in that:
the breaker apparatus further includes
detecting means (9, 10, 11, 13, 14, 17) for detecting current flowing through said grounding switch (5A, 6A) and for generating an output corresponding to said current; and
control means (13) for controlling said grounding switch (5A, 6A) in dependence on said output of said detecting means (9, 10, 11, 13, 14, 17), said control means (13) being arranged to control opening and closing of said grounding switch (5A, 6A) such that said grounding switch (5A, 6A) is prevented from opening unless said output corresponds to a predetermined value of said current.

5. A breaker apparatus according to claim 4, wherein said detecting means comprises a resistor (9, 10) connected in series with said grounding switch, and current detection means (17) for detecting current flowing in said resistor (9, 10).

6. A breaker apparatus according to claim 4, wherein said detecting means comprises a current transformer (31).

7. A breaker apparatus according to claim 6, wherein said current transformer (31) has a core (33) with a high magnetic flux saturation level.

8. A breaker apparatus according to claim 4, wherein said detecting means comprises a Hall-effect element (34).

9. A breaker apparatus according to any one of claims 4 to 8, wherein the predetermined value in zero.

10. A power line system, comprising:
at least one power line; and
a breaker apparatus connected to each end of said at least one power line, said breaker apparatus being according to any one of claims 1 to 8.

11. A power line system according to claim 10, wherein said control means (13) of each of said breaker apparatus are in common.

12. A method of operating a breaker apparatus for a power line (1A, 1B, 1C), the breaker apparatus having a power line breaker (3A to 3C; 4A to 4C) with a first input connected to said power line (1A, 1B, 1C) and a second input for connection to an external circuit (22A to 22C; 23A to 23C), and a grounding switch connected between said first input of said power line breaker (3A to 3C; 4A to 4C) and ground;
the method comprising the steps of:
operating said power line breaker (3A to 3C; 4A to 4C) to disconnect said power line (1A, 1B, 1C) from said external circuit (22A to 22C; 23A to 23C); and
closing said grounding switch (5A, 6A) to connect said power line (1A, 1B, 1C) to ground;
characterized in that:
current flowing in said grounding switch (5A, 6A) is monitored; and
the opening of said grounding switch (5A, 6A) is controlled to prevent opening of said grounding switch (5A, 6A) when said current is less than a predetermined value.

13. A method according to claim 12, wherein said step of closing said grounding switch (5A, 6A) is arranged to occur at a time corresponding to a peak value of an induced voltage on said power line (1A, 1B, 1C).

14. A method of operating a breaker system for a power line (1A, 1B, 1C); the breaker system comprising first and second power line breakers (3A to 3C; 4a to 4C) each having a first input connected to a respective first and second end of said power (1A, 1B, 1C) line and a second input for connection to a respective external circuit (23A to 23C; 22A to 22C), grounding switches (5A, 6A) connected respectively between the first input of said first and second power line breakers (3A, 3B, 3C, 4A to 4C) and ground;
the method comprising the steps of:
operating said first and second power line breakers (3A to 3C; 4A to 4C) to disconnect said power line (1A, 1B, 1C) from said first and second external circuits (23A to 23C; 22A to 22C); and
closing said first and second grounding switches (5A, 6A) to connect the first and second ends of said power line (1A, 1B, 1C) to ground;
characterized in that:
current respectively flowing in said first and second grounding switches (5A, 6A) is monitored; and
the opening of said first and second grounding switches (5A, 6A) is controlled to prevent opening of either of said first and second grounding switches (5A, 6A) when the respective current flowing therein is greater than a predetermined value.

15. A method according to claim 14, wherein the step of closing said first and second grounding switches (5A, 6A) is controlled so as to control the respective directions of the direct component of current through said first and second grounding switches (5A, 6A).

16. A method according to claim 14 or claim 15, wherein the step of closing said first and second grounding switches comprising closing said first grounding switch (5A) and subsequently closing said second grounding switch (6A) after a time period which is not more than 1/6 of the period of voltage on said power line (1A, 1B, 1C).

17. A method according to any one of claims 12 to 16, wherein the predetermined value is zero.
